**Europäisches Patentamt**

**European Patent Office**

**Office européen des brevets**

(19)

(11) Veröffentlichungsnummer : **0 358 997 B1**

(12) **EUROPÄISCHE PATENTSCHRIFT**

(45) Veröffentlichungstag der Patentschrift :
**17.03.93 Patentblatt 93/11**

(51) Int. Cl.[5] : **C04B 35/00,** C01G 3/00,
H01L 39/24

(21) Anmeldenummer : **89115625.9**

(22) Anmeldetag : **24.08.89**

(54) **Verfahren zur Herstellung eines keramischen Hochtemperatur-Supraleiters des Typs SEBa2Cu3O6,5+Y' wobei SE = Seltenes Erdmetall, 0 y 1 durch Kalzinieren und reaktives Sintern.**

(30) Priorität : **12.09.88 CH 3401/88**

(43) Veröffentlichungstag der Anmeldung :
**21.03.90 Patentblatt 90/12**

(45) Bekanntmachung des Hinweises auf die
Patenterteilung :
**17.03.93 Patentblatt 93/11**

(84) Benannte Vertragsstaaten :
**CH DE FR GB LI NL SE**

(56) Entgegenhaltungen :
**ADVANCED CERAMIC MATERIALS, Band 2, Nr. 3B, "Special Issue", Juli 1987, Seiten 343-352, ACerS; B. DUNN et al.: "Properties of superconducting oxides prepared by the amorphous citrate process"**
**JAPANESE JOURNAL OF APPLIED PHYSICS, Band 26, Nr. 5, Mai 1987, Seiten L734-L735; K. KANEKO et al.: "On the coprecipitation method for the preparation of high TcM-X-Cu-O(M=Ba,Sr,X=La,Y) system"**
**Japanese Journal of Applied Physics, Band 26, Nr. 6, Juni 1987, Seiten L734-L735, K. Kaneko et al.**

(73) Patentinhaber : **ASEA BROWN BOVERI AG
Haselstrasse
CH-5401 Baden (CH)**

(72) Erfinder : **Kloucek, Franz, Dr.
Brückenstrasse 10
CH-5430 Wettingen (CH)**

## Beschreibung

TECHNISCHES GEBIET

Technologie der elektrischen Supraleiter. In neuester Zeit nimmt die Bedeutung von Werkstoffen, welche supraleitende Eigenschaften haben, mehr und mehr zu. Die Entdeckung von neuen supraleitenden Werkstoffen, insbesondere des Typs seltene Erden/Ba/Cu/O, führte zu einer beträchtlichen Erweiterung der Anwendungsmöglichkeiten für Supraleiter, da diese Stoffe bereits bei Temperaturen oberhalb 50 K supraleitend werden.

Die Erfindung bezieht sich auf die Weiterentwicklung und Verbesserung von Erzeugnissen aus einem keramischen Hochtemperatur-Supraleiter, wobei den Bedürfnissen der industriellen Grossproduktion Rechnung getragen werden soll.

Insbesondere betrifft sie ein Verfahren zur Herstellung eines keramischen Hochtemperatur-Supraleiters des Typs $SEBa_2Cu_3O_{6,5+y}$, wobei SE = seltenes Erdmetall, $0 < y < 1$ bedeutet.

STAND DER TECHNIK

Keramische Hochtemperatur-Supraleiter des Typs $SEBa_2Cu_3O_{6,5+y}$ (SE = seltenes Erdmetall; $0 < y < 1$) stellen chemisch grundsätzlich komplexe Oxyde dar. Es war daher naheliegend, bei ihrer Herstellung allgemein von den einzelnen Oxyden, allenfalls von Karbonaten der betreffenden Metalle auszugehen. Die Ausgangsmaterialien müssen ausserordentlich feinkörnig vorliegen, damit die Stoffe - ohne unerwünschte schmelzflüssige Phasen bilden zu können - im zur Verfügung stehenden engen Temperaturbereich durch reaktives Sintern miteinander reagieren und auf diese Weise die komplexe Verbindung aufbauen könnnen. Da die Diffusionswege auch bei feinkörnigem Ausgangsmaterial noch vergleichsweise lang sind, sind zur Bildung des gute Supraleitereigenschaften aufweisenden komplexen Oxyds hohe Glühtemperaturen und lange Glühzeiten erforderlich.

Bei zahlreichen Herstellungsverfahren wird unter anderem $BaCO_3$ als Ausgangsmaterial für den Ba-Träger benutzt oder es wird im Verlauf des Prozesses als Zwischenprodukt gebildet. Nun ist aber $BaCO_3$ ausgerechnet eines der thermodynamisch stabilsten Karbonate, das sich erst oberhalb 900 °C merklich zersetzt. Der Gleichgewichtspunkt liegt sogar noch einige Hundert °C höher. Die Anwesenheit des überschüssigen, auszutreibenden $CO_2$ stört die angestrebte Reaktion, da die Gefahr besteht, dass die einzelnen Pulverpartikel bei den hohen erforderlichen Temperaturen mindestens teilweise zusammensintern und örtlich einen Teil des $CO_2$ gefangenhalten, bevor die gewünschte kohlenstoff-freie komplexe Supraleiter-Verbindung im ganzen kompakten Körper gebildet wird. Es bleiben Karbonate bestehen, die als unerwünschte Fremdphasen an den Korngrenzen die Stromtragfähigkeit beeinträchtigen können. Während des zur Bildung des Supraleiters notwendigen Reaktionsprozesses findet ein Kornwachstum statt und die Pulverpartikel sintern zu gröberen Agglomeraten zusammen, die nachträglich erneut gemahlen werden müssen, um akzeptable Partikelgrössen zu erhalten. Auf diese Weise können daher keine extrem fein körnigen Keramikkörper gesintert werden wie das wünschenswert ist (Ziel: Korndurchmesser < 1 μm). Um zu brauchbaren Supraleiterkörpern zu gelangen, muss nach der hier beschriebenen Methode der Mahl- und Glühprozess (Kalzinieren und reaktives Sintern) mehrmals wiederholt werden. Trotzdem weisen die Pulverpartikel in der Regel eine breit gefächerte Grössenverteilung auf und haben eine unregelmässige Form. Beides erschwert die Weiterverarbeitung zu dünnen Schichten und Filamenten.

Es ist auch schon vorgeschlagen worden, den Glühprozess der Pulvermischung unter Vakuum durchzuführen, um das Austreiben von $CO_2$ aus dem Ausgangsmaterial $BaCO_3$ zu erleichtern und niedrigere C-Gehalte im Endprodukt zu erreichen. Die Glühtemperaturen konnten indessen nicht wesentlich gesenkt werden, so dass die besagten Probleme weiterhin bestehen.

Wird von karbonatfreien Mischungen von Oxyden ausgegangen, so erübrigt sich zwar das Austreiben des $CO_2$, jedoch bleiben die restlichen, oben erwähnten Schwierigkeiten bestehen.

Zum Stand der Technik werden die nachfolgenden Literaturstellen zitiert:
- A.K. Dhingra, "Alumina fibre EP", Phil. Trans. R. Soc. Lond. A 294, 411 - 417 (1980)
- F.Kloucek, W.E.Rhine, H.K.Bowen, "Thick films of $YBa_2Cu_3O_x$ fabricated from colloidal solutions", Internat. Conf. on High-$T_c$ Superconductors, Interlaken 1988
- C.A. Costa, M. Ferretti , C.L.Olcese and M.R.Cimberle, C. Ferdeghini, G.L.Nicchiotti , A.S. Siri, C.Rizzuto, "Synthesis of $YBa_2 Cu_3O_{7-x}$ polycristalline superconductors from Ba peroxide: First physico-chemical characterization", Journal of Crystal Growth 85 (1987) 623-627, North-Holland, Amsterdam
- Naoki Uno, Noritsugu Enomoto, Yasuzo Tanaka and Hiroshi Takami, "Synthesis of Superconductive Oxides by Vacuum Calcination Method", Japanese Journal of Applied Physics Vol. 27, No. 6, June, 1988, pp.

L1003-L1006

Die bekannten Methoden zur Herstellung von Hochtemperatur-Supraleiterkörpern sind aufwendig und kostspielig und lassen bezüglich Qualität, Reproduzierbarkeit und Möglichkeiten der Weiterverarbeitung noch vieles zu wünschen übrig. Es besteht daher ein grosses Bedürfnis, die Verfahren weiter zu entwicklen und zu vervollkommen.

Der Erfindung liegt die Aufgabe zugrunde, ein Verfahren zur Herstellung eines keramischen Hochtemperatursupraleiters des Typs $SEBa_2Cu_3O_{6,5+y}$, wobei SE = seltenes Erdmetall und $0<y<1$ bedeuten, bei dem das Erzeugnis einem Trocknungs- und Kalzinierungsprozess zum sukzessiven Austreiben des $H_2O$ und $CO_2$ unter zusätzlicher Anwendung von Vakuum und einem Sinterprozess zur Konsolidierung und Verdichtung unter Sauerstoffatmosphäre unterworfen wird, anzugeben. Das erfindungsgemässe Verfahren soll einfach in der Handhabung sein und zu reproduzierbaren, die Weiterverarbeitung erleichternden und neue Wege erschliessenden Erzeugnissen führen. Das Verfahren soll insbesondere die Herstellung ultrafeinkörniger, homogener Sinterkörper gewährleisten, welche tunlichst frei von schädlichen Fremdphasen sind und einen möglichst niedrigen Rest-C-Gehalt aufweisen. Das Erzeugnis soll eine hohe Stromtragfähigkeit besitzen und die rationelle Weiterverarbeitung zu dünnen Fasern mit glatter Oberfläche und geringer Fehlerdichte sowie zu dünnen und dicken Schichten ermöglichen. Die Glühtemperaturen sollen merklich gesenkt und die Glühzeiten verkürzt werden.

Diese Aufgabe wird dadurch gelöst, dass im eingangs erwähnten Verfahren als Ausgangssubstanzen in Wasser oder einem organischen Lösungsmittel, ausgewählt aus der Gruppe der Alkohole und Glykole, gut lösliche anorganische und/oder organische einfache oder komplexe Verbindungen des seltenen Erdmetalls, Bariums und Kupfers verwendet werden, dass die Ausgangssubstanzen im besagten Lösungsmittel gelöst und mit der Lösung eines Fällungsmittels gemischt werden, welches mit den Salzen des seltenen Erdmetalls, Bariums und Kupfers unter Bildung einer schwerlöslichen Verbindung reagiert, und dass die auf diese Weise durch Copräzipitation erzeugte komplexe $SE/Ba_2/Cu_3$-Verbindung mehrmals gewaschen, zentrifugiert und in einer Flüssigkeit zu einer Suspension von festen Teilchen dispergiert oder getrocknet wird, und dass das Erzeugnis einem Trocknungs- und Kalzinierungsprozess zum sukzessiven Austreiben des $H_2O$ und $CO_2$ unter zusätzlicher Anwendung von Vakuum und einem Sinterprozess zur Konsolidierung und Verdichtung unter Sauerstoffatmosphäre unterworfen wird.

## WEG ZUR AUSFÜHRUNG DER ERFINDUNG

Die Erfindung wird anhand der nachfolgenden, durch Figuren näher erläuterten Ausführungsbeispiele beschrieben.

Dabei zeigt:

Fig. 1 ein Fliessdiagramm (Blockdiagramm) zur Herstellung eines Zwischenprodukts nach der simultanen Fällungsmethode (Copräzipitation),

Fig. 2 ein Fliessdiagramm (Blockdiagramm) zur Herstellung eines Körpers aus einem Hochtemperatur-Supraleiter mit Anwendung einer Wärmebehandlung unter Vakuum gemäss Verfahren A,

Fig. 3 ein Flessdiagramm (Blockdiagramm) zur Herstellung eines Körpers aus einem Hochtemperatur-Supraleiter mit Anwendung einer Wärmebehandlung unter Vakuum gemäss Verfahren B,

Fig. 4 ein Diagramm verschiedener Betriebsparameter in Funktion der Zeit unter Anwendung des Verfahrens A.

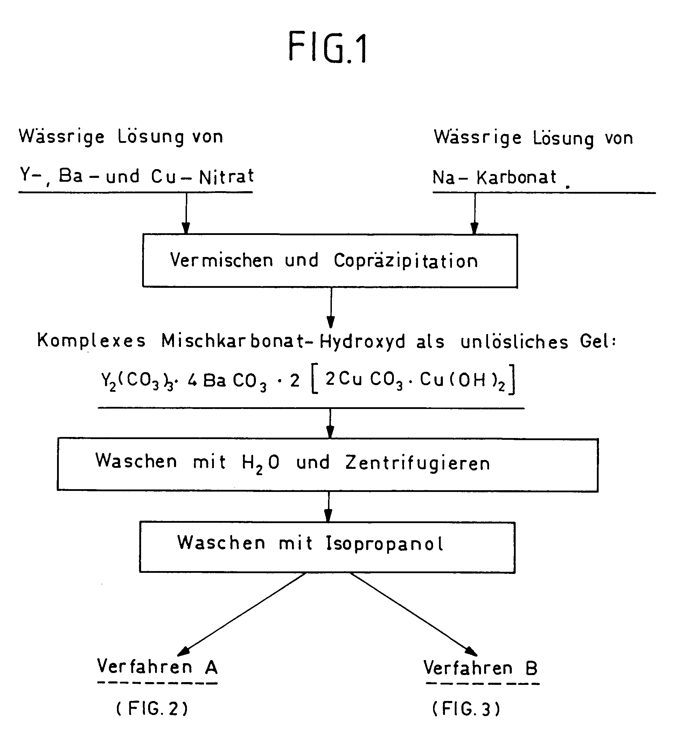

In Fig. 1 ist ein Fliessdiagramm als Blockdiagramm zur Herstellung eines Zwischenprodukts (Vorläufer) nach der Methode der simultanen Fällung (Copräzipitation) dargestellt. Das Diagramm bedarf keines speziellen Kommentars. Das Prinzip der Copräzipitation ist geläufig. Es wird von sich gegenseitig verträglichen Lösungen ausgegangen, wobei durch Vermischen mit einem ebenfalls als Lösung vorliegenden Fällungsmittel unlösliche Produkte in Form von einer Suspension fester Partikel, eines Gels etc. ausgefällt und weiterbehandelt werden. Letzteres kann gemäss Verfahren A oder Verfahren B erfolgen.

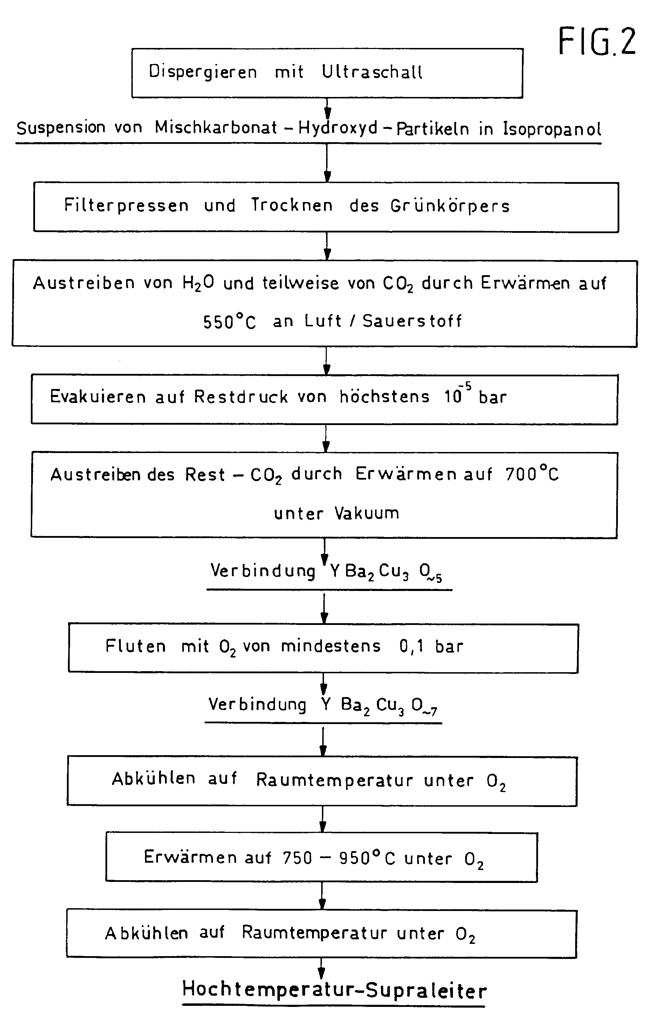

Fig. 2 stellt ein Fliessdiagramm als Blockdiagramm zur Herstellung eines Körpers aus einem Hochtemperatur-Supraleiter mit Anwendung einer Wärmebehandlung unter Vakuum gemäss Verfahren A dar. Nach dem Trocknen und Austreiben des $H_2O$ und eines Teils des $CO_2$ wird die Substanz unter Vakuum gesetzt und der Rest des $CO_2$ bei leicht erhöhter Temperatur vollends ausgetrieben. Dann wird die Substanz unter $O_2$-Druck gesetzt und durch $O_2$-Aufnahme in den supraleitenden Zustand versetzt. Am Schluss findet eine nochmalige Wärmebehandlung unter $O_2$-Atmosphäre statt.

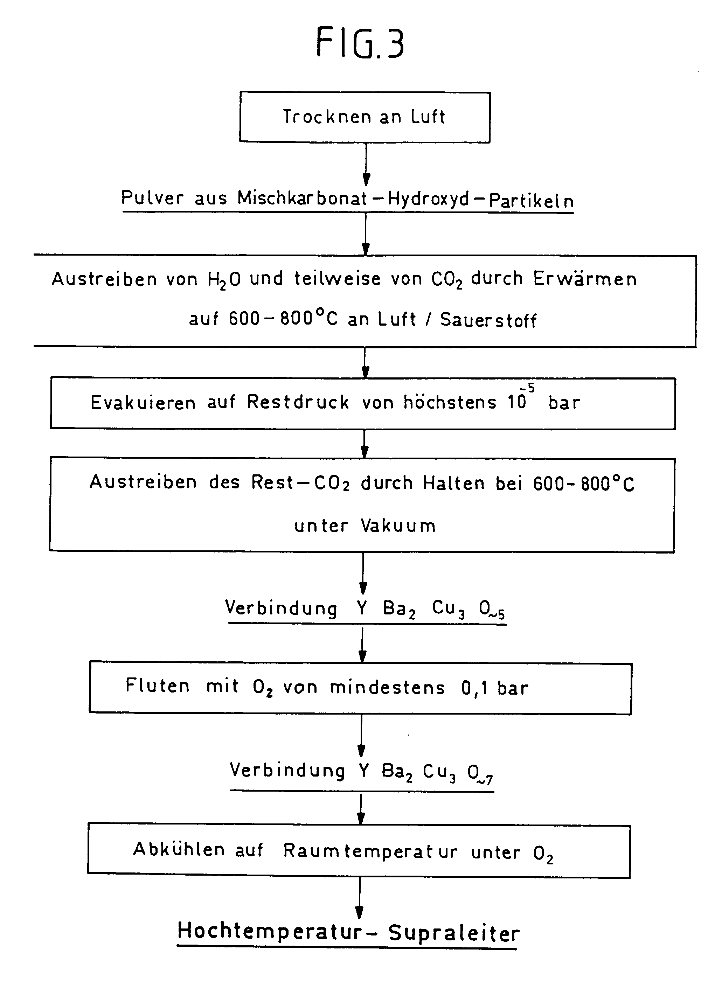

Fig. 3 zeigt ein Fliessdiagramm als Blockdiagramm zur Herstellung eines Körpers aus einem Hochtemperatur-Supraleiter mit Anwendung einer Wärmebehandlung unter Vakuum gemäss Verfahren B. Das Austreiben des $H_2O$ und eines Teils des $CO_2$ erfolgt hier bei etwas höherer Temperatur und das Austreiben des Rest-$CO_2$ bei unveränderter Temperatur unter Vakuum. Das Fluten mit $O_2$ zur Ueberführung der Substanz in den sup-

3

raleitenden Zustand spielt sich ähnlich wie beim Verfahren A ab.

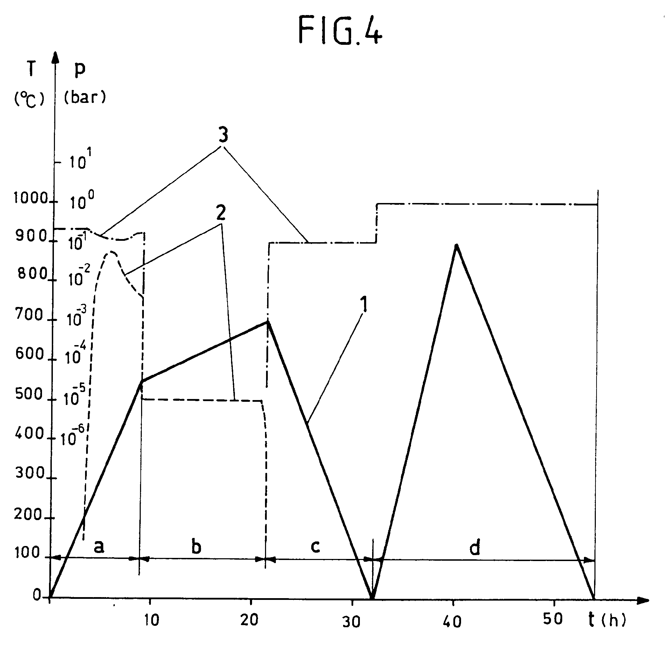

In Fig. 4 ist ein Diagramm dargestellt, das schematisch den Verlauf verschiedener Betriebsparameter in Funktion der Zeit zeigt, wobei grundsätzlich das Verfahren A zugrunde gelegt wurde. Auf der Abszisse ist die Zeit t in h aufgetragen. Die Ordinate weist auf der linken Seite eine Temperaturskala T in °C und auf der rechten Seite eine logarithmische Skala für den Partialdruck p in bar auf. 1 (durchgezogene Linie) ist der Verlauf der Temperatur T in Funktion der Zeit t. Die gestrichelte Linie 2 stellt schematisch den Partialdruck p des $CO_2$ ($p_{CO_2}$) über der Zeit t dar, wobei, nur der relevante Abschnitt eingezeichnet ist. Die strichpunktierte Linie 3 bezieht sich auf den schematischen Verlauf des Partialdrucks p des $O_2$ ($p_{O_2}$) in Funktion der Zeit t, wobei wiederum nur die interessierenden Abschnitte eingezeichnet sind. a ist der Zeitabschnitt des Austreibens des $H_2O$ und eines Teils des $CO_2$ aus der Substanz unter einer Luft- oder $O_2$-Atmosphäre. Dabei wird die Temperatur langsam von Raumtemperatur auf 550 °C gesteigert. b ist der Zeitabschnitt des Austreibens des Rest-$CO_2$ unter Vakuum, wobei die Temperatur langsam von 550 °C auf 700 °C gesteigert wird. c stellt den Zeitabschnitt der Behandlung unter $O_2$-Atmosphäre dar, wobei die Substanz langsam von 700 °C auf Raumtemperatur abgekühlt wird. d ist der Zeitabschnitt der zustäzlichen Wärmebehandlung unter $O_2$-Atmosphäre (im vorliegenden Fall unter leicht erhöhtem Druck), die in einer langsamen Erwärmung auf 900 °C und einer langsamen Abkühlung auf Raumtemperatur besteht. Im Zeitabschnitt a steigt der Partialdruck $p_{CO_2}$ mit steigender Temperatur zunächst an. Dabei verdrängt das ausgetriebene $CO_2$ teilweise das $O_2$ der Ofenatmosphäre, dessen Partialdruck $p_{O_2}$ vorübergehend leicht abfällt. Am Ende dieses Abschnitts fällt $p_{CO_2}$ wieder etwas ab, da das Austreiben des $CO_2$ nachlässt. Gleichzeitig stellt sich der ursprüngliche Partialdruck $p_{O_2}$ (z.B. für Luft als Ofenatmosphäre) wieder ein. Selbstverständlich ist der Verlauf nur schematisch zu verstehen. Die tatsächlichen Partialdruckverhältnisse hängen sehr stark von der Ofenkonstruktion, der Ofenführung, der Gasbewegung und der Form und Grösse des herzustellenden Supraleiterkörpers ab. Zu Beginn des Zeitabschnittes b fällt zufolge des Vakuums der Partialdruck $p_{CO_2}$ auf $10^{-5}$ bar ab und wird auf diesem Wert ungefähr konstant gehalten. Es handelt sich praktisch um ein "Absaugen" des $CO_2$, welches den Reaktionsraum kontinuierlich verlässt. Der Partialdruck $p_{O_2}$ ist in diesem Abschnitt irrelevant und hängt von der Dichtheit des Ofens und den Ofenbaumaterialien ab. Für das Verfahren wesentlich ist nur $p_{CO_2}$. Zu Beginn des Zeitabschnittes c wird der Ofen mit $O_2$ gesenkt und $p_{O_2}$ nimmt schlagartig zu. Sein Wert wird dann auf mindestens 0,1 bar gehalten. Der Partialdruck $p_{CO_2}$ ist in diesem Abschnitt nicht mehr relevant. Im ganzen Zeitabschnitt d wird mit leicht erhöhtem Partialdruck $p_{O_2}$ (im vorliegenden Fall 1 bar) gefahren.

AUSFÜHRUNGSBEISPIEL 1:

Siehe Figuren 1, 2 und 4 !

Zunächst wurde eine geeignete Lösung von Y-, Ba- und Cu-Salzen hergestellt. Dabei wurde wie folgt verfahren:

Es wurden stöchiometrische Mengen der Nitrate bzw. Nitrat-Hydrate des Y, Ba und Cu in $H_2O$ gelöst:

$$Y(NO_3)_3 \cdot 6\ H_2O$$
$$Ba(NO_3)_2$$
$$Cu(NO_3)_2 \cdot 2,57\ H_2O$$

Die Flüssigkeit wurde so eingestellt, dass auf das $Y/Ba_2/Cu_3$-Verhältnis bezogen eine 0,025 molare Lösung vorlag. Die genaue Zusammensetzung der Nitrate war zuvor gravimetrisch durch Pyrolyse (Y; Ba) und durch elektrochemische Abscheidung (Cu) bestimmt worden. Die wässrige Salzlösung wurde auf 12 °C abgekühlt und unter ständigem Rühren langsam in eine 0,2 molare wässrige Lösung von $Na_2CO_3$ eingetropft. Der $p_H$-Wert dieser Lösung betrug 11,5, die Temperatur 12 °C. Das Eintropfen wurde so lange fortgesetzt, bis der $p_H$-Wert auf 10,7 abfiel. Dabei wurde ein blaues Gel ausgefällt, welches das gewünschte Zwischenprodukt als unlösliche komplexe Verbindung darstellte. Es handelte sich praktisch um eine isomorphe Mischung von Y-Karbonat, Ba-Karbonat und Cu-Karbonat-Hydroxyd (Azurit).

Dieses Mischkarbonat-Hydroxyd entsprach ungefähr der Formel:

$$Y_2(CO_3)_3 \cdot 4\ BaCO_3 \cdot 2 \left[ 2\ CuCO_3 \cdot Cu(OH)_2 \right]$$

Das gelartige Produkt wurde in eine Zentrifuge abgefüllt und das blaue Präzipitat unter einer Beschleunigung von 900 g während 5 min abzentrifugiert. Die überstehende, eine hohe Konzentration von Na-Ionen ent-

4

haltende klare Flüssigkeit wurde dekantiert. Das blaue Gel wurde mehrmals mit doppelt deionisiertem $H_2O$ gewaschen und wieder zentrifugiert. Dabei wurde an $BaCO_3$ gesättigtes $H_2O$ verwendet, um einen Ba-Verlust auszuschalten. Am Schluss wurde das Präzipitat mit Isopropanol gewaschen. Eine Untersuchung zeigte, dass die Elemente Y, Ba und Cu in jedem Partikel des Zwischenproduktes vollkommen homogen verteilt vorlagen, ganz im Gegensatz zu mechanischen Gemengen beim herkömmlichen Oxydpulververfahren (selbst wenn die Pulver noch so fein gemahlen sind).

Das Zwischenprodukt wurde nun gemäss Fig. 2 (Verfahren A) weiterbehandelt. Das Präzipitat wurde in Isopropanol mittels Ultraschall dispergiert und die Suspension in ein Filterpresswerkzeug eingefüllt und das überschüssige Isopropanol ausgepresst. Dann wurde der auf diese Weise gebildete Grünkörper getrocknet. Es wurden rissfreie zylindrische Probekörper von 20 mm Durchmesser und 2 mm Dicke hergestellt. Die Grünfestigkeit war ausreichend für die Weiterverarbeitung. Die Grünkörper wurden an Luft mit einer Geschwindigkeit von durchschnittlich 1 K/min auf 550 °C erhitzt (Zeitabschnitt a in Fig. 4). Dabei wurde vor allem $H_2O$ und ein Teil des $CO_2$ nebst allfällig im Verlauf des Prozesses gebildeter Kohlenwasserstoffe ausgetrieben. Das dabei gebildete Zwischenprodukt besteht nun vorwiegend aus den Oxyden des Y und Cu und dem Karbonat des Ba. Der Ofen wurde nun unter ein Vakuum mit einem Restdruck von $10^{-5}$ bar gesetzt und die Temperatur langsam (0,2 K/min) bis auf 700 °C gesteigert. Dabei wurde das Rest-$CO_2$ praktisch vollständig ausgetrieben (Zeitabschnitt b in Fig. 4). Gleichzeitig setzte die Reaktion der Oxyde untereinander ein, so dass als weiteres Zwischenprodukt eine Verbindung gebildet wurde, die ungefähr die nachfolgende Zusammensetzung aufwies:

$$YBa_2Cu_3O_{\sim 5}$$

Nun wurde der Ofen mit $O_2$ mit einem Druck von ca. 0,1 bar geflutet und langsam abgekühlt. Dabei nahm der Probekörper $O_2$ auf, so dass die Verbindung gebildet wurde, die annähernd der folgenden Formel entsprach (Zeitabschnitt c in Fig. 4) :

$$YBa_2Cu_3O_{\sim 7}$$

Der Probekörper wurde anschliessend unter einem $O_2$-Druck von 1 bar nochmals langsam auf 900 °C aufgeheizt und wieder langsam bis auf Raumtemperatur abgekühlt (Zeitabschnitt d in Fig. 4). Nach der Entnahme aus dem Ofen waren die Sinterkörper sehr stark geschrumpft, zeigten jedoch keinerlei Risse. Die Untersuchung ergab, dass die Proben aus der supraleitenden Phase bestanden, die ungefähr die nachfolgende Zusammensetzung aufwies:

$$YBa_2Cu_3O_{6,5 + y},$$

wobei Y ca. 0,4 bis 0,5 betrug.

Die relative Dichte erreichte 80 bis 90 % des theoretischen Wertes.

## AUSFÜHRUNGSBEISPIEL 2:

Siehe Figuren 1 und 3 !

Mit den gleichen Ausgangsmaterialien wurden zunächst gemäss Beispiel 1 Nitrat- und Karbonatlösungen hergestellt und ein komplexes Mischkarbonat-Hydroxyd als unlösliches Gel ausgefällt.

Nach dem Waschen mit Isopropanol wurde das Zwischenprodukt gemäss Fig. 3 (Verfahren B) weiterbehandelt. Das Präzipitat wurde an Luft bei einer Temperatur von 60 °C während 24 h getrocknet und das gebildete Pulver aus Mischkarbonat-Hydroxyd-Partikeln zwecks Austreiben von $H_2O$ und einem Teil des $CO_2$ an Luft auf eine Temperatur von 600 °C erhitzt. Dann wurde der Ofen bis auf einen Restdruck von höchstens $10^{-5}$ bar evakuiert und die Temperatur von 600 °C während einer Zeit von 48 h gehalten. Dabei wurde das restliche $CO_2$ vollständig ausgetrieben und ein bezüglich $O_2$ unterdotiertes hochreaktives Zwischenprodukt erzeugt, das einer $Y/Ba_2/Cu_3$-Verbindung entsprach, die ungefähr die nachfolgende Zusammensetzung aufwies:

$$YBa_2Cu_xO_{\sim 5}$$

Dann wurde der Ofen ähnlich Beispiel 1 mit $O_2$ mit einem Druck von ca. 0,5 bar geflutet und langsam abgekühlt. Durch $O_2$-Aufnahme wurde dabei die nachfolgende Verbindung gebildet:

$$YBa_2Cu_3O_{\sim 7}$$

Dieses Endprodukt stellte die supraleitende Phase dar, was durch Röntgenbeugung und Schwebeversuche bestätigt wurde. Die Pulverteilchen waren äusserst feinkörnig mit einem Partikeldurchmesser unter 1 μm und zeichneten sich durch grosse Gleichmässigkeit aus. Sie waren nur leicht agglomeriert, und die Bindungen zwischen ihnen konnten durch Ultraschall ohne Mühe aufgebrochen werden.

## AUSFÜHRUNGSBEISPIEL 3:

Zunächst wurde aus den Ausgangsmaterialien gemäss Beispiel 1 ein Gel als komplexes Mischkarbonat-Hydroxyd gefällt und nach Beispiel 2 an Luft von 60 °C während 24 h zu einem Pulver getrocknet.

Zwecks Austreiben von $H_2O$ und einem Teil des $CO_2$ wurde das Pulver aus ultrafeinen Mischkarbonat-Hydroxyd-Partikeln langsam unter Sauerstoff von 1 bar auf eine Temperatur von 700 °C erwärmt und wieder auf Raumtemperatur abgekühlt. Das im wesentlichen aus den Oxyden des Y und Cu und $BaCO_3$ bestehende Zwischenprodukt wurde nun ähnlich Beispiel 1 (Verfahren A) mittels Ultraschall in Isopropanol dispergiert und in einer Filterpresse zu zylindrischen Körpern von 25 mm Durchmesser und 3 mm Dicke verpresst. Die Körper wurden getrocknet und ähnlich Beispiel 1 unter Vakuum (Restdruck $10^{-5}$ bar) auf eine Temperatur von 700 °C erwärmt. Dabei wurde der Rest des $CO_2$ ausgetrieben, so dass im wesentlichen eine Verbindung der nachfolgenden Zusammensetzung gebildet wurde:

$$YBa_2Cu_3O_{\sim 5}$$

Der Ofen wurde dann mit $O_2$ von 1 bar Druck geflutet und langsam auf Raumtemperatur abgekühlt. Die dabei durch $O_2$-Aufnahme gebildete Verbindung hatte die nachfolgende Zusammensetzung:

$$YBa_2Cu_3O_{\sim 7}$$

Bei einer Dichte von 90 % des theoretischen Wertes konnte die Supraleitfähigkeit im ganzen Körper einwandfrei nachgewiesen werden.

Die Erfindung ist nicht auf die Ausführungsbeispiele begrenzt.

Das Verfahren zur Herstellung eines keramische Hochtemperatur-supraleiters des Typs $SEBa_2Cu_3O_{6,5+y}$, wobei SE = seltenes Erdmetall und $0 < y < 1$ bedeutet, wird grundsätzlich so durchgeführt, dass als Ausgangssubstanzen in Wasser oder einem organischen Lösungsmittel, ausgewählt aus der Gruppe der Alkohole und Glykole, gut lösliche anorganische und/oder organische einfache oder komplexe Verbindungen des seltenen Erdmetalls, Bariums und Kupfers verwendet werden, wobei die Ausgangssubstanzen im besagten Lösungsmittel gelöst und mit der Lösung eines Fällungsmittels gemischt werden, welches mit den Salzen des seltenen Erdmetalls, Bariums und Kupfers unter Bildung einer schwerlöslichen Verbindung reagiert, und dann die auf diese Weise durch Copräzipitation erzeugte komplexe $SE/Ba_2/Cu_3$-Verbindung mehrmals gewaschen, zentrifugiert und in einer Flüssigkeit zu einer Suspension von festen Teilchen dispergiert oder getrocknet wird, und schliesslich das Erzeugnis einem Trocknungs- und Kalzinierungsprozess zum sukzessiven Austreiben des $H_2O$ und $CO_2$ unter zusätzlicher Anwendung von Vakuum und einem Sinterprozess zur Konsolidierung und Verdichtung unter Sauerstoffatmosphäre unterworfen wird.

Nach einer Variante A wird die in einer Flüssigkeit zu einer Suspension von festen Teilchen dispergierte komplexe $SE/Ba_2/Cu_3$-Verbindung in einer Filterpresse von der Flüssigkeit getrennt und getrocknet und der auf diese Weise hergestellte Grünkörper zwecks Austreiben des $H_2O$ und teilweise des $CO_2$ zunächst bei 550 °C geglüht, unter ein Vakuum entsprechend einem Restdruck von höchstens $10^{-5}$ bar gesetzt und unter diesem Vakuum zwecks Austreiben des restlichen $CO_2$ und Sintern bei 700 °C geglüht, unter einen $O_2$-Druck von mindestens 0,1 bar gesetzt und auf Raumtemperatur abgekühlt. Vorzugsweise wird der Sinterkörper vor oder nach dem Abkühlen auf Raumtemperatur zusätzlich im Temperaturbereich zwischen 750 und 950 °C unter $O_2$-Atmosphäre von mindestens 0,1 bar Druck geglüht und auf Raumtemperatur abgekühlt.

Nach einer Variante B wird die getrocknete komplexe $SE/Ba_2/Cu_3$-Verbindung unter Luft oder Sauerstoff zunächst zwecks Austreiben des $H_2O$ und teilweise des $CO_2$ bei 600 bis 800 °C geglüht, unter ein Vakuum von höchstens $10^{-5}$ bar Restdruck gesetzt und unter diesem Vakuum zwecks Austreiben des restlichen $CO_2$ und Sintern bei der vorgenannten Temperatur geglüht, unter einen $O_2$-Druck von mindestens 0,1 bar gesetzt und auf Raumtemperatur abgekühlt.

Grundsätzlich wird das Verfahren so durchgeführt, dass der $CO_2$-Partialdruck unterhalb von $10^{-5}$ bar gehalten und dabei durch reaktives Sintern eine sauerstoffarme oxydische Verbindung der ungefähren Zusammensetzung $SEBa_2Cu_3O_5$ gebildet wird und der nachfolgende Glühprozess unter $O_2$-Atmosphäre dergestalt geführt wird, dass die vorgenannte Verbindung durch Sauerstoffaufnahme in die supraleitende Substanz mit der ungefähren Zusammensetzung $SEBa_2Cu_3O_7$ übergeführt wird.

In vorteilhafter Weise wird das Glühen unter $O_2$-Atmosphäre zusätzlich unter Aufwendung von mechanischem Druck in einer Form oder unter allseitigem Druck als heiss-isostatisches Pressen durchgeführt und der Hochtemperatur-Supraleiter bis zum porenfreien Endprodukt dicht gesintert.

Die Temperatur von 550 °C ist diejenige Temperatur, bei der unter Atmosphärendruck alles $H_2O$ ausgetrieben ist und auch die Y- und Cu-Karbonate vollständig zerfallen sind. Je nach Grösse und Form des Körpers genügen zum vollständigen Austreiben des $CO_2$ unter Vakuum Temperaturen von 600 °C ... 700 °C ... 800 °C. Temperatur und Dauer dieses Glühprozesses können aufeinander abgestimmt werden. Für alle praktischen Zwecke genügt ein Vakuum mit $10^{-5}$ bar Restdruck.

Vorteilhafterweise werden als Ausgangssubstanzen wässrige Lösungen von Nitraten und als Fällungsmittel Natrium- und/oder Kaliumkarbonat benutzt, wobei die durch Copräzipitation erzeugte komplexe $SE/Ba_2/Cu_3$-Verbindung ein isomorphes Mischkarbonat-Hydrat ist, welches als Gel ausfällt und in ein ultrafeinkörniges Pulver einer Partikelgrösse von höchstens 5 µm übergeführt wird. Vorzugsweise werden stöchiometrische Mengen der Nitrate und/oder Nitrat-Hydrate des Y, Ba und Cu im Elementverhältnis $Y : Ba : Cu = 1 : 2 : 3$ in Wasser derart gelöst, dass bezogen auf den metallischen Anteil $YBa_2Cu_3$ der Stoffe eine 0,025 molare Lösung erzeugt wird, welche bei einer Temperatur von unter 15 °C in eine 0,2 molare wässrige Lösung von $Na_2CO_3$ eingetropft und das auf diese Weise ausgefällte Gel zentrifugiert, gewaschen, wieder zentrifugiert und schliesslich mit Isopropanol gewaschen, getrocknet, gepresst, kalziniert, reaktiv gesintert und auf Raumtemperatur abgekühlt wird. Die ausgefällte komplexe Verbindung ist ein amorphes, als Gel vorliegendes Mischkarbonat-Hydroxyd der ungefähren Formel

$$Y_2(CO_3)_3 \cdot 4BaCO_3 \cdot 2\left[2CuCO_3 \cdot Cu(OH)_2\right] \cdot$$

Selbstverständlich können als SE auch andere Elemente der seltenen Erdmetalle als Y, zum Beispiel Er, Pr, Gd, Tm, Ho, Nd oder Dy Verwendung finden. Ba kann zu geringen Anteilen durch Sr ersetzt sein, Cu desgleichen zu geringen Anteilen durch Ni.

Durch das neue Verfahren können homogene ultrafeinkörnige Hochtemperatur-Supraleiter erzeugt werden, welche sich besonders zur Weiterverarbeitung zu dünnen Drähten und Filmen eignen. Durch die Homogenität, Feinkörnigkeit und den geringen Anteil an Fehlstellen wird die Stromtragfähigkeit des Enderzeugnisses merklich erhöht.

## Patentansprüche

1. Verfahren zur Herstellung eines keramischen Hochtemperatursupraleiters des Typs $SEBa_2Cu_3O_{6,5+y}$, wobei SE = seltenes Erdmetall und $0<y<1$ bedeutet,

bei dem das Erzeugnis einem Trocknungs- und kalzinierungsproze$_s$s zum sukzessiven Austreiben des $H_2O$ und $CO_2$ unter zusätzlicher Anwendung von Vakuum und einem Sinterprozess zur Konsolidierung und Verdichtung unter Sauerstoffatmosphäre unterworfen wird, dadurch gekennzeichnet, dass

als Ausgangssubstanzen in Wasser oder einem organischem Lösungsmittel, ausgewählt aus der Gruppe der Alkohole und Glykole, gut lösliche anorganische und/oder organische einfache oder komplexe Verbindungen des seltenen Erdmetalls, Barium und Kupfers verwendet werden,

die Ausgangssubstanzen in besagtem Lösungsmittel gelöst und mit der Lösung eines Fällungsmittels gemischt werden, welches mit den Salzen des seltenen Erdmetalls, Barium und Kupfers unter Bildung einer schwerlöslichen Verbindung reagiert, und

die auf diese Weise durch Kopräzipitation erzeugte komplexe $SE/Ba_2/Cu_3$-Verbindung mehrmals gewaschen, zentrifugiert und in einer Flüssigkeit zu einer Suspension von festen Teilchen dispergiert oder getrocknet wird und anschliessend besagtem Trocknungs- und Kalzinierungsprozess unterworfen wird.

2. Verfahren nach Anspruch 1, dadurch gekennzeichnet, dass die in einer Flüssigkeit zu einer Suspension von festen Teilchen dispergierte komplexe $SE/Ba_2/Cu_3$-Verbindung in einer Filterpresse von der Flüssigkeit getrennt und getrocknet wird, und der auf diese Weise hergestellte Grünkörper zwecks Austreiben des $H_2O$ und teilweise des $CO_2$ zunächst bei 550 °C geglüht, unter ein Vakuum entsprechend einem Restdruck von höchstens $10^{-5}$ bar gesetzt und unter diesem Vakuum zwecks Austreiben des restlichen $CO_2$ und Sintern bei 700 °C geglüht, unter einen $O_2$-Druck von mindestens 0,1 bar gesetzt und auf Raumtemperatur abgekühlt wird.

3. Verfahren nach Anspruch 2, dadurch gekennzeichnet, dass der Sinterkörper vor oder nach dem Abkühlen auf Raumtemperatur zusätzlich im Temperaturbereich zwischen 750 und 950 °C unter $O_2$-Atmosphäre von mindestens 0,1 bar Druck geglüht und auf Raumtemperatur abgekühlt wird.

4. Verfahren nach Anspruch 1, dadurch gekennzeichnet, dass die getrocknete komplexe $SE/Ba_2/Cu_3$-Verbindung unter Luft oder Sauerstoff zunächst zwecks Austreiben des $H_2O$ und teilweise des $CO_2$ bei 600 bis 800 °C geglüht, unter ein Vakuum von höchsten $10^{-5}$ bar Restdruck gesetzt und unter diesem Vakuum zwecks Austreiben des restlichen $CO_2$ und Sintern bei der vorgenannten Temperatur geglüht, unter einen $O_2$-Druck von mindestens 0,1 bar gesetzt und auf Raumtemperatur abgekühlt wird.

5. Verfahren nach einem der vorangegangenen Ansprüche, dadurch gekennzeichnet, dass die Vakuumbehandlung derart durchgeführt wird, dass der $CO_2$-Partialdruck unterhalb von $10^{-5}$ bar gehalten und dabei durch reaktives Sintern eine sauerstoffarme oxidische Verbindung der ungefähren Zusammensetzung $SEBa_2Cu_3O_5$ gebildet wird und dass der nachfolgende Glühprozess unter $O_2$-Atmosphäre dergestalt ge-

führt wird, dass die vorgenannte Verbindung durch Sauerstoffaufnahme in die supraleitende Substanz mit der ungefähren Zusammensetzung SEBa$_2$Cu$_3$O$_7$ übergeführt wird.

6. Verfahren nach Anspruch 1, dadurch gekennzeichnet, dass das Glühen unter O$_2$-Atmosphäre zusätzlich unter Aufwendung von mechanischem Druck in einer Form durchgeführt und der Hochtemperatur-Supraleiter dicht gesintert wird.

7. Verfahren nach Anspruch 1, dadurch gekennzeichnet, dass das Glühen unter O$_2$-Atmosphäre zusätzlich unter allseitigem mechanischem Druck als heiss-isostatisches Pressen bis zu einem dicht gesinterten, porenfreien Endprodukt durchgeführt wird.

8. Verfahren nach Anspruch 1, dadurch gekennzeichnet, dass als Ausgangssubstanzen wässrige Lösungen von Nitraten und als Fällungsmittel Natrium- und/oder Kaliumkarbonat benutzt werden und dass die durch Copräzipitation erzeugte komplexe SE/Ba$_2$/Cu$_3$-Verbindung ein isomorphes Mischkarbonat-Hydrat ist, welches als Gel ausgefällt und in ein ultrafeinkörniges Pulver einer Partikelgrösse von höchstens 5 μm übergeführt wird.

9. Verfahren nach Anspruch 8, dadurch gekennzeichnet, dass stöchiometrische Mengen der Nitrate und-/oder Nitrat-Hydrate des Y, Ba und Cu im Elementverhältnis Y : Ba : Cu = 1 : 2 : 3 in Wasser gelöst werden, derart, dass bezogen auf den metallischen Anteil YBa$_2$Cu$_3$ der Stoffe eine 0,025 molare Lösung erzeugt wird, welche bei einer Temperatur von unter 15 °C in eine 0,2 molare wässrige Lösung von Na$_2$CO$_3$ eingetropft wird, und dass das auf diese Weise ausgefällte Gel zentrifugiert, gewaschen, wieder zentrifugiert und schliesslich mit Isopropanol gewaschen, getrocknet, gepresst, kalziniert, reaktiv gesintert und auf Raumtemperatur abgekühlt wird.

10. Verfahren nach Anspruch 8 und 9, dadurch gekennzeichnet, dass die ausgefällte komplexe Verbindung ein amorphes, als Gel vorliegendes Mischkarbonat-Hydroxyd der ungefähren Formel
$$Y_2(CO_3)_3 \cdot 4BaCO_3 \cdot 2\,[\,2CuCO_3 \cdot Cu(OH)_2\,]$$
ist.

## Claims

1. Process for producing a ceramic high-temperature superconductor of the REBa$_2$Cu$_3$O$_{6.5+y}$ type, where RE = rare earth metal and 0 < y < 1, in which process the product is subjected to a drying and calcining procedure for gradually expelling the H$_2$O and CO$_2$ with the additional application of vacuum and to a sintering procedure under an oxygen atmosphere to consolidate and compact it, characterised in that inorganic and/or organic, simple or complex compounds of the rare earth metal, barium and copper which are readily soluble in water or an organic solvent selected from the group comprising the alcohols and glycols are used as starting substances, the starting substances are dissolved in the said solvent and mixed with the solution of a precipitating agent which reacts with the salts of the rare earth metal, barium and copper to form a sparingly soluble compound, and the complex RE/Ba$_2$/Cu$_3$ compound formed by coprecipitation in this way is washed several times, centrifuged and dispersed in a liquid to form a suspension of solid particles or dried, and then subjected to said drying and calcining procedure.

2. Process according to Claim 1, characterised in that the complex RE/Ba$_2$/Cu$_3$ compound dispersed in a liquid to form a suspension of solid particles is separated from the liquid in a filter press and dried, and the green body produced in this manner is first annealed at 550°C for the purpose of expelling the H$_2$O and some of the CO$_2$, placed under a vacuum corresponding to a residual pressure not exceeding 10$^{-5}$ bar and annealed at 700°C under this vacuum for the purpose of expelling the remaining CO$_2$ and sintering, placed under an O$_2$ pressure of not less than 0.1 bar and cooled to room temperature.

3. Process according to Claim 2, characterised in that the sintered body is additionally annealed before or after cooling to room temperature in the temperature range between 750 and 950°C under an 02 atmosphere at a pressure of not less than 0.1 bar and cooled to room temperature.

4. Process according to Claim 1, characterised in that the dried complex RE/Ba$_2$/Cu$_3$ compound is first annealed at 600 to 800°C under air or oxygen for the purpose of expelling the H$_2$O and some of the CO$_2$, placed under a vacuum with a residual pressure not exceeding 10$^{-5}$ bar and annealed under this vacuum at the abovementioned temperature for the purpose of expelling the remaining $CO_2$ and sintering, placed under an $O_2$ pressure of not less than 0.1 bar and cooled to room temperature.

5. Process according to one of the preceding claims, characterised in that the vacuum treatment is conducted in such a way that the $CO_2$ partial pressure is kept below $10^{-5}$ bar and under these conditions a low-oxygen compound of the approximate composition $REBa_2Cu_3O_5$ is formed by reactive sintering and in that the subsequent annealing process is conducted under $O_2$ atmosphere in a manner such that the abovementioned compound is converted into the superconducting substance of the approximate composition $REBa_2Cu_3O_7$ by oxygen absorption.

6. Process according to Claim 1, characterised in that the annealing under $O_2$ atmosphere is carried out additionally with the application of mechanical pressure in a mould and the high-temperature superconductor is compacted by sintering.

7. Process according to Claim 1, characterised in that the annealing under $O_2$ atmosphere is carried out additionally with all-round mechanical pressure as hot isostatic pressing until a compactly sintered, pore-free final product is formed.

8. Process according to Claim 1, characterised in that aqueous solutions of nitrates are used as starting substances and sodium carbonate and/or potassium carbonate as precipitating agent and in that the complex $RE/Ba_2/Cu_3$ compound produced by coprecipitation is an isomorphic carbonate-hydrate mixture which precipitates as a gel and is converted into an ultrafine-grained powder having a particle size not exceeding 5 $\mu$m.

9. Process according to Claim 8, characterised in that stoichiometric amounts of the nitrates and/or nitrate hydrates of Y, Ba and Cu are dissolved in water in the element ratio of Y:Ba:Cu = 1:2:3 in a manner such that, based on the metallic $YBa_2Cu_3$ component of the substances, a 0.025 molar solution is produced which is added dropwise to a 0.2 molar aqueous solution of $Na_2CO_3$ at a temperature of less than 15°C, and in that the gel precipitated in this manner is centrifuged, washed, centrifuged again and finally washed with isopropanol, dried, pressed, calcined, reactively sintered and cooled to room temperature.

10. Process according to Claims 8 and 9, characterised in that the precipitated complex compound is an amorphous carbonate-hydroxide mixture existing as a gel of the approximate formula
$$Y_2(CO_3)_3 \cdot 4BaCO_3 \cdot 2\ [2CuCO_3 \cdot Cu(OH)_2].$$

**Revendications**

1. Méthode de fabrication d'un conducteur céramique à haute température du type $SEBa_2Cu_3O_{6,5+y}$, dans lequel SE signifie métal de terres rares et 0 < y < 1, dans laquelle le produit est soumis à un processus de séchage et de calcination pour l'élimination successive de $H_2O$ et de $CO_2$ sous utilisation complémentaire de vide et d'un processus de frittage sous atmosphère d'oxygène pour consolidation et densification, caractérisée en ce que,

des composés du métal de terres rares, du barium et du cuivre qui sont facilement solubles, qui sont de nature minérale et/ou organique et qui sont simples ou complexes, sont utilisés en tant que substances initiales dans l'eau ou dans un solvant organique, choisi parmi le groupe des alcools et des glycols,

les substances initiales sont dissoutes dans ledit solvant et sont mélangées avec la solution d'un agent de précipitation, qui réagit avec les sels du métal de terres rares, du barium et du cuivre pour former un composé difficilement soluble, et

le composé complexe $SE/Ba_2/Cu_3$ obtenu de cette façon par coprécipitation est lavé plusieurs fois, centrifugé et dispersé dans un liquide pour former une suspension de particules solides ou est séché et soumis finalement audit processus de séchage et de calcination.

2. Méthode selon la revendication 1, caractérisée en ce que le composé complexe $SE/Ba_2/Cu_3$ dispersé dans un liquide pour former une suspension de particules solides est séparé du liquide dans un filtre-presse et séché, et le compact vert ainsi obtenu est tout d'abord calciné à 550°C en vue de l'élimination de $H_2O$ et d'une partie du $CO_2$, placé sous un vide correspondant à une pression résiduelle d'au maximum $10^{-5}$ bar et calciné à 700°C sous ce vide pour éliminer le $CO_2$ restant et pour réaliser le frittage, et soumis à une pression de $O_2$ d'au moins 0,1 bar et est refroidi à température ambiante.

3. Méthode selon la revendication 2, caractérisée en ce que le corps de frittage est soumis, avant ou après le refroidissement à température ambiante, à une calcination supplémentaire dans le domaine de température entre 750° et 950°C sous atmosphère d'$O_2$ à une pression d'au moins 0,1 bar et est refroidi à la température ambiante.

4. Méthode selon la revendication 1, caractérisée en ce que le composé complexe séché SE/$Ba_2$/$Cu_3$ est tout d'abord calciné de 600° à 800°C sous air ou sous oxygène pour éliminer $H_2O$ et une partie du $CO_2$, est placé sous un vide d'une pression résiduelle d'au maximum $10^{-5}$ bar et est calciné à la température citée plus haut sous ce vide pour éliminer le $CO_2$ restant et pour réaliser le frittage, est soumis à une pression d'$O_2$ d'au moins 0,1 bar et est refroidi à la température ambiante.

5. Méthode selon l'une des revendications précédentes, caractérisée en ce que le traitement sous vide est effectué de telle sorte que la pression partielle de $CO_2$ est maintenue en-dessous de $10^{-5}$ bar et qu'il se forme ainsi, par frittage réactif, un composé pauvre en oxygène, obtenu par voie d'oxydation, de composition approximative $SEBa_2Cu_3O_5$ et que le procédé de calcination suivant est effectué sous atmosphère d'$O_2$ de telle manière que le composé cité plus haut est transformé par absorption d'oxygène en la substance supraconductrice ayant la composition approximative $SEBa_2Cu_3O_7$.

6. Méthode selon la revendication 1, caractérisée en ce que la calcination sous atmosphère d'$O_2$ est effectuée de plus par application d'une pression mécanique dans un moule et que le supraconducteur à haute température est fritté de façon dense.

7. Méthode selon la revendication 1, caractérisée en ce que la calcination sous atmosphère de $O_2$ est effectuée de plus sous une pression mécanique omnidirectionnelle en tant que compression isostatique à haute température pour obtenir un produit final qui est fritté de façon dense et qui est dépourvu de pores.

8. Méthode selon la revendication 1, caractérisée en ce que des solutions aqueuses de nitrates sont utilisées comme substances initiales et du carbonate de sodium et/ou du carbonate de potassium est utilisé en tant qu'agent de précipitation et que le composé complexe SE/$Ba_2$/$Cu_3$ obtenu par coprécipitation est un composé mixte isomorphe carbonate-hydraté, qui précipite en tant que gel et qui est transformé en une poudre ultra fine d'une grosseur de particules d'au maximum 5 $\mu$m.

9. Méthode selon la revendication 8, caractérisée en ce que des quantités stoechiométriques des nitrates et/ou des nitrates-hydratés de Y, Ba et Cu sont dissoutes dans l'eau dans le rapport élémentaire Y : Ba : Cu = 1 : 2 : 3 de telle manière que, sur la base de la part métallique $YBa_2Cu_3$ de la substance, une solution de molarité 0,025 soit obtenue, ajoutée goutte à goutte à une température inférieure à 15°C à une solution aqueuse de $Na_2Co_3$ de molarité 0,2, et que le gel précipité de cette façon soit centrifugé, lavé, centrifugé à nouveau et finalement lavé à l'isopropanol, séché, comprimé, calciné, fritté réactivement et refroidi à la température ambiante.

10. Méthode selon la revendication 8 et 9, caractérisée en ce que le composé complexe précipité est un composé mixte carbonate-hydroxyde, présent en tant que gel, de la formule approximative
$$Y_2(CO_3)_3 \cdot 4BaCO_3 \cdot 2[2CuCO_3 \cdot Cu(OH)_2]$$

# FIG.1

Wässrige Lösung von

Y-, Ba - und Cu - Nitrat

Wässrige Lösung von

Na - Karbonat .

```
┌─────────────────────────────────────────┐
│      Vermischen und  Copräzipitation      │
└─────────────────────────────────────────┘
```

Komplexes Mischkarbonat- Hydroxyd als unlösliches Gel:

$$Y_2(CO_3)_3 \cdot 4\,Ba\,CO_3 \cdot 2\left[\,2\,Cu\,CO_3 \cdot Cu\,(OH)_2\right]$$

```
┌─────────────────────────────────────────────┐
│   Waschen  mit  H₂O  und  Zentrifugieren     │
└─────────────────────────────────────────────┘
```

```
┌─────────────────────────────────────────────┐
│        Waschen  mit  Isopropanol             │
└─────────────────────────────────────────────┘
```

Verfahren  A

( FIG. 2 )

Verfahren  B

(FIG. 3 )

FIG.2

```
┌─────────────────────────────────────────────────┐
│        Dispergieren  mit  Ultraschall            │
└─────────────────────────────────────────────────┘
                        │
                        ▼
 Suspension von Mischkarbonat – Hydroxyd – Partikeln in Isopropanol
 ─────────────────────────────────────────────────────────────────
                        │
                        ▼
┌─────────────────────────────────────────────────┐
│    Filterpressen  und  Trocknen  des Grünkörpers  │
└─────────────────────────────────────────────────┘
                        │
                        ▼
┌─────────────────────────────────────────────────┐
│ Austreiben von $H_2O$ und teilweise von $CO_2$ durch Erwärmen auf │
│                                                   │
│      550°C  an Luft / Sauerstoff                 │
└─────────────────────────────────────────────────┘
                        │
                        ▼
┌─────────────────────────────────────────────────┐
│ Evakuieren auf Restdruck von höchstens $10^{-5}$ bar │
└─────────────────────────────────────────────────┘
                        │
                        ▼
┌─────────────────────────────────────────────────┐
│ Austreiben des Rest – $CO_2$ durch Erwärmen auf 700°C │
│                                                   │
│              unter Vakuum                         │
└─────────────────────────────────────────────────┘
                        │
                        ▼
          Verbindung $Y Ba_2 Cu_3 O_{\sim 5}$
          ─────────────────────────────────
                        │
                        ▼
┌─────────────────────────────────────────────────┐
│  Fluten  mit $O_2$ von mindestens  0,1 bar       │
└─────────────────────────────────────────────────┘
                        │
                        ▼
          Verbindung $Y Ba_2 Cu_3 O_{\sim 7}$
          ─────────────────────────────────
                        │
                        ▼
┌─────────────────────────────────────────────────┐
│  Abkühlen  auf  Raumtemperatur unter $O_2$       │
└─────────────────────────────────────────────────┘
                        │
                        ▼
┌─────────────────────────────────────────────────┐
│  Erwärmen auf 750 – 950°C unter $O_2$            │
└─────────────────────────────────────────────────┘
                        │
                        ▼
┌─────────────────────────────────────────────────┐
│  Abkühlen auf  Raumtemperatur unter $O_2$        │
└─────────────────────────────────────────────────┘
                        │
                        ▼
          Hochtemperatur–Supraleiter
          ──────────────────────────
```

# FIG.3

Trocknen an Luft

↓

Pulver aus Mischkarbonat−Hydroxyd−Partikeln

↓

Austreiben von $H_2O$ und teilweise von $CO_2$ durch Erwärmen auf $600-800°C$ an Luft / Sauerstoff

↓

Evakuieren auf Restdruck von höchstens $10^{-5}$ bar

↓

Austreiben des Rest−$CO_2$ durch Halten bei $600-800°C$ unter Vakuum

↓

Verbindung $Y\,Ba_2\,Cu_3\,O_{\sim5}$

↓

Fluten mit $O_2$ von mindestens $0,1$ bar

↓

Verbindung $Y\,Ba_2\,Cu_3\,O_{\sim7}$

↓

Abkühlen auf Raumtemperatur unter $O_2$

↓

Hochtemperatur− Supraleiter

# FIG.4